# EUROPÄISCHE PATENTSCHRIFT

(11) **EP 1 628 223 B1**
(45) Veröffentlichungstag und Bekanntmachung des Hinweises auf die Patenterteilung: **02.04.2014**
(21) Anmeldenummer: 05017953.0
(22) Anmeldetag: 18.08.2005
(51) Int. Cl.: G06F 12/02, G06F 12/08

(54) **Schreiben von Daten in einen nichtflüchtigen Speicher eines tragbaren Datenträgers**
Writing data to a non-volatile memory of a portable data carrier
Ecriture de données dans une mémoire non-volatile d'un support de données portable

(30) Priorität: 19.08.2004 DE 102004040296
(43) Veröffentlichungstag der Anmeldung: 22.02.2006
(73) Patentinhaber: Giesecke & Devrient GmbH, 81677 München (DE)
(72) Erfinder: Leineweber, Harald, 81379 München (DE)

(56) Entgegenhaltungen:
- EP-A1- 1 413 959
- WO-A-02/057995
- FR-A- 2 846 770
- JP-A- 2003 308 240
- ZACCAI A: "SRAM BASED CACHE FOR FLASH MEMORY/DISK" MOTOROLA TECHNICAL DEVELOPMENTS, MOTOROLA INC. SCHAUMBURG, ILLINOIS, US, Bd. 32, 1. September 1997 (1997-09-01), Seite 30, XP000741115 ISSN: 0887-5286

## Beschreibung

Die Erfindung betrifft einen tragbaren Datenträger, der beispielsweise als Chipkarte in unterschiedlichen Bauformen oder als Chipmodul oder als sonstiges ressourcenbeschränktes System ausgestaltet sein kann. Insbesondere betrifft die Erfindung das Schreiben von Daten in einen nichtflüchtigen Speicher eines solchen Datenträgers.

Tragbare Datenträger weisen in der Regel einen Prozessorkern und mehrere in unterschiedlichen Technologien ausgestaltete Speicher auf. In einer typischen Ausgestaltung sind ein flüchtiger Arbeitsspeicher, ein nichtflüchtiger überschreibbarer Speicher und ein Festwertspeicher vorgesehen. Der Arbeitsspeicher kann beispielsweise als RAM, der nichtflüchtige überschreibbare Speicher als EEPROM oder Flash-Speicher, und der Festwertspeicher als maskenprogrammiertes ROM ausgestaltet sein.

Während des Betriebs des Datenträgers müssen persistente Daten im nichtflüchtigen überschreibbaren Speicher abgelegt werden. Schreibzugriffe auf diesen Speicher benötigen aber relativ viel Zeit, die für ein EEPROM oder einen Flash-Speicher typischerweise 3 - 10 ms beträgt. Dies ist um mehrere Zehnerpotenzen mehr als die typische Schreibzeit in den Arbeitsspeicher. Während dieser Zeit ist der Prozessorkern des Datenträgers für andere Aufgaben blockiert. Es besteht ein Bedürfnis, trotz der langen Schreibzeiten in den nichtflüchtigen überschreibbaren Speicher eine hohe Leistungsfähigkeit des Datenträgers bei der Programmabarbeitung zu erzielen.

Naturgemäß fallen die Schreibzeiten des nichtflüchtigen überschreibbaren Speichers um so mehr ins Gewicht, je häufiger Schreibzugriffe auf diesen Speicher erforderlich sind. Dies betrifft in besonderem Maße Datenträger, die nach der *Java-Card*™-Spezifikation der Firma Sun Microsystems, Inc., Palo Alto, Kalifornien, USA, ausgestaltet sind, da gemäß dieser Spezifikation alle Objektfelder sowie diverse weitere Datenstrukturen im nichtflüchtigen überschreibbaren Speicher abgelegt werden müssen. Wegen der Vielzahl der erforderlichen Schreibzugriffe beim Ausführen typischer *Java*™-Anwendungen wird die Leistungsfähigkeit eines *Java-Card*-Datenträgers erheblich beeinträchtigt. Es besteht daher gerade hier ein besonderes Bedürfnis nach leistungssteigernden Maßnahmen.

Aus der Firmenschrift "*GPOS-32PK™ ― Global Platform™ Operating System for Java™ Cards with PK Cryptography*", herausgegeben von der Firma jNet Technology, Inc., Cupertino, Kalifornien, USA, ist es bekannt, *Java*™-Objekte in einem Cache-Bereich im Arbeitsspeicher zwischenzuspeichern, um die Anzahl der Schreibvorgänge im nichtflüchtigen überschreibbaren Speicher zu minimieren. Diese Vorgehensweise verkleinert zwar das Problem, weil oft mehrere Schreibvorgänge, die auf eine einzige Speicherseite erfolgen, zusammengefaßt werden können. Es besteht jedoch nach wie vor Bedarf nach weiterer Verbesserung.

Aus WO 01/88926 A1 ist ein tragbarer Datenträger bekannt, der beim Empfang eines Befehls zum Einschreiben von Daten in einen nichtflüchtigen überschreibbaren Speicher einen Löschvorgang für denjenigen Speicherbereich, in den die Daten eingeschrieben werden sollen, startet. Parallel zu diesem Löschvorgang werden die Daten empfangen und in einem Pufferspeicher abgelegt. Erst wenn der Löschvorgang beendet worden ist, werden die Daten vom Pufferspeicher in den nichtflüchtigen überschreibbaren Speicher übertragen.

Aus der WO 02/057995 ist ein Flash-Speichersystem bestehend aus mehreren Sets von Flash-Speicherchips bekannt, wobei zwei Sets jeweils ein Flash-Bufferchip vorgeordnet ist. Die Flash-Bufferchips sind über einen Flashbus jeweils mit einem DMA-Controller verbunden, die wiederum über einen lokalen Bus mit einem lokalen Prozessor verbunden sind. Der lokale Prozessor ist über den lokalen Bus weiter mit einem Cache-Speicher verbunden. Zweck der Struktur ist es, ein Flash-Speichersystem hinsichtlich Schreiben und Lesen schneller zu machen. Erreicht wird die Beschleunigung, indem zu schreibende Daten zunächst im Cache zwischengespeichert werden und dort daraufhin geprüft werden, welchen Flashchip genau sie betreffen. Alle Daten, die unterschiedliche Flashchips betreffen, werden gemeinsam verarbeitet, insbesondere erfolgt ein gleichzeitiges Vorablöschen der betroffenen Flashchips. Als weitere Beschleunigungsmaßnahme wird vorgeschlagen, dass mehrere DMA-Controller wechselweise auf einen Flashchip zugreifen. Ferner wird zur Entlastung des lokalen Prozessors vorgeschlagen, die DMA-Controller als separate Bausteine auszuführen, die unabhängig von dem lokalen Prozessor arbeiten. Die unabhängigen DMA-Bausteine teilen dabei dem lokalen Prozessor jeweils ihren aktuellen Arbeitszustand mit.

Auf dem Gebiet der tragbaren Datenträger sind Einheiten zur hardwareunterstützten Speicherverwaltung (MMUs - *memory management units*) bekannt. Auf den Seiten 107 - 109 des Buches "Handbuch der Chipkarten" von W. Rankl und W. Effing, Hanser Verlag, 3. Auflage, 1999, sind solche Einheiten beschrieben, die die Einhaltung von Speichergrenzen überwachen. EP 0 230 353 A2 und US 2003/0222877 A1 offenbaren Beispiele für Koprozessoren, die bei größeren Systemen dazu vorgesehen sind, bestimmte Tätigkeiten zu übernehmen. JP 2003/308 240 A offenbart ein System bestehend aus einem Host in Gestalt eines Notebook-Computers oder eines Handys und einer Speicherkarte, das derart ausgestaltet ist, dass bei einer Datenkommunikation zwischen Host und Speicherkarte eine Garbage Collection nach Möglichkeit vermieden wird, um die Datenübertragungsgeschwindigkeit zu erhöhen. Aus der FR-A-2 846 770 ist eine Chipkarte bekannt, auf der eine virtuelle Maschine nach dem Java-Card-Standard realisiert ist.

EP 1413 959 A1 offenbart für Flash-Speicherkarten ein Verfahren, das es erlaubt Speicherseiten, die weitestgehend ungültige Daten enthalten, aber dennoch nicht überschrieben werden können, weil sie zumindest auch ein noch gültiges Restdatum enthalten, wieder freizugeben. Die gültigen Restdaten werden dazu gesammelt in eine neue Speichers eite kopiert und die Ursprungsseiten anschließend gelöscht und für ein Neubeschreiben freigegeben.

Die Erfindung hat die Aufgabe, einen tragbaren Datenträger mit hoher Leistungsfähigkeit bei der Programmausführung bereitzustellen. In bevorzugten Ausgestaltungen soll die Erfindung insbesondere bei der Ausführung von Programmen, die eine Vielzahl von Schreibzugriffen auf einen nichtflüchtigen überschreibbaren Speicher des Datenträgers erfordern, vorteilhaft einsetzbar sein.

Erfindungsgemäß wird diese Aufgabe ganz oder zum Teil durch ein Verfahren gemäß Anspruch 1, einen tragbaren Datenträger gemäß Anspruch 10 sowie ein Computerprogrammprodukt gemäß Anspruch 13 gelöst. Die abhängigen Ansprüche betreffen bevorzugte Ausführungsformen der Erfindung.

Die Erfindung geht von an sich bekannten Ausgestaltungen aus, bei denen ein Pufferspeicher für die in den nichtflüchtigen überschreibbaren Speicher einzuschreibenden Daten vorgesehen ist. Eine Grundidee der erfindungsgemäßen Weiterentwicklung ist es, eine Steuereinheit einzusetzen, die für die Übertragung der Daten von dem Pufferspeicher in den nichtflüchtigen überschreibbaren Speicher parallel zur weiteren Programmausführung durch den Prozessorkern des Datenträgers sorgt. Hierdurch wird erreicht, daß die Programmausführung durch den Schreibvorgang in den nichtflüchtigen überschreibbaren Speicher im Regelfall nicht blockiert wird. Der Prozessorkern kann somit ein vorgegebenes Programm effizienter ausführen. Durch den Einsatz der Erfindung verringert sich nicht nur die für die Erledigung einer Aufgabe benötigte Zeitdauer, sondern auch die durchschnittliche Reaktionszeit des Datenträgers auf eine eingehende Anforderung.

In bevorzugten Ausgestaltungen ist die Steuereinheit mit relativ geringem Hardwareaufwand aufgebaut. Beispielsweise kann die einzige Funktion der Steuereinheit darin bestehen, einen durch Registerinhalte der Steuereinheit definierten Datenblock von dem Pufferspeicher in den nichtflüchtigen überschreibbaren Speicher zu übertragen. Die Steuereinheit kann als Teil des Prozessorkerns oder als separate Baugruppe - auf demselben Halbleiterchip wie der Prozessorkern oder auf einem anderen Halbleiterchip - ausgebildet sein.

Der Hardwareaufwand kann besonders gering gehalten werden, wenn die Verwaltung des Pufferspeichers möglichst weitgehend von dem durch den Prozessorkern ausgeführten Programm übernommen wird. So kann z.B. vorgesehen sein, daß das ausgeführte Programm bestimmt, welchen Datenblock die Steuereinheit übertragen soll und wann die Übertragung beginnen soll.

Hierbei können an sich bekannte Vorgehensweisen zur Verwaltung eines durch Software implementierten Cache ("Software-Cache") herangezogen werden. Es sind jedoch auch Ausgestaltungen der Erfindung vorgesehen, bei denen die genannten Funktionen ganz oder zum Teil hardwaremäßig implementiert sind. Beispielsweise kann die Funktionsweise eines an sich zum Schreiben von Daten in den nichtflüchtigen überschreibbaren Speicher verwendeten Maschinenbefehls ("EEMOV-Befehl") so abgewandelt werden, daß dieser den Pufferspeicher als Cache nutzt.

In bevorzugten Ausführungsformen erfolgen Schreibzugriffe des Prozessorkerns während der Programmausführung zunächst in den Pufferspeicher. Entsprechend wird bei Lesezugriffen vorzugsweise zunächst überprüft, ob die zu lesenden Daten im Pufferspeicher enthalten sind. Ist dies der Fall, werden die Daten aus dem Puffespeicher ausgelesen; andernfalls wird auf den nichtflüchtigen überschreibbaren Speicher zugegriffen.

Vorzugsweise stößt der Prozessorkern die hardwareunterstützte Datenübertragung durch die Steuereinheit an, sobald ein vorgegebener Füllungsgrad des Pufferspeichers erreicht ist. Hierbei wird vorzugsweise zunächst überprüft, ob die Steuereinheit gerade einen Übertragungsvorgang ausführt. Ist dies der Fall, wartet der Prozessorkern vorzugsweise so lange, bis die Steuereinheit wieder verfügbar ist. In der Praxis wird diese Situation, die eine Verzögerung der Programmausführung mit sich bringt, allerdings nur selten auftreten.

Vorzugsweise stellt die Steuereinheit eine Rückmeldung über die Übertragung der Daten bereit. Diese Rückmeldung - beispielsweise der Inhalt eines Steuerregisters der Steuereinheit - kann angeben, ob eine Übertragung gegenwärtig läuft oder ob die Übertragung erfolgreich beendet worden ist oder ob die Übertragung fehlgeschlagen ist.

In besonders einfachen Ausgestaltungen ist ein vorgegebener Bereich im Arbeitsspeicher des tragbaren Datenträgers als Pufferspeicher reserviert. Es sind jedoch auch Ausgestaltungen vorgesehen, bei denen der Pufferspeicher als separates Speicherfeld - in derselben oder einer anderen Speichertechnologie wie der Arbeitsspeicher - ausgestaltet ist.

In bevorzugten Ausgestaltungen ist der nichtflüchtige überschreibbare Speicher ein EEPROM oder ein Flash-Speicher. Solche Speicher sind in der Regel seitenweise organisiert. Vorzugsweise ist in diesen Fällen auch der Pufferspeicher konzeptuell in entsprechende Seitenabschnitte untergliedert. Der durch die Steuereinheit ausgeführte Schreibvorgang in den nichtflüchtigen überschreibbaren Speicher kann, je nach den Erfordernissen, auch das vorherige Löschen von Speicherseiten im nichtflüchtigen überschreibbaren Speicher umfassen.

In bevorzugten Ausgestaltungen weisen das Computerprogrammprodukt und/oder die Vorrichtung Merkmale auf, die den hier beschriebenen und/oder den in den abhängigen Verfahrensansprüchen genannten Merkmalen entsprechen.

Das erfindungsgemäße Computerprogrammprodukt kann ein körperliches Medium sein, beispielsweise ein Halbleiterspeicher oder eine Diskette oder eine CD-ROM. Das Computerprogrammprodukt kann jedoch auch ein nicht-körperliches Medium sein, beispielsweise ein über ein Computernetzwerk übermitteltes Signal. Das Computerprogrammprodukt kann insbesondere eine virtuelle Maschine und/oder ein Betriebsprogramm enthalten, die/das bei der Herstellung und/oder Initialisierung eines tragbaren Datenträgers in diesen eingespielt wird/werden.

Weitere Merkmale, Vorteile und Aufgaben der Erfindung gehen aus der folgenden genauen Beschreibung eines Ausführungsbeispiels und mehrerer Ausführungsalternativen hervor. Es wird auf die schematischen Zeichnungen verwiesen, in denen zeigen:
Fig. 1 ein Blockdiagramm mit Funktionseinheiten eines tragbaren Datenträgers nach einem Ausführungsbeispiel der Erfindung,
Fig. 2 eine schematische Darstellung der Bedeutung der Registerinhalte einer Steuereinheit in dem Ausführungsbeispiel von Fig.1, und
Fig. 3 ein beispielhaftes Ablaufdiagramm der Programmausführung in dem Ausführungsbeispiel von Fig. 1.

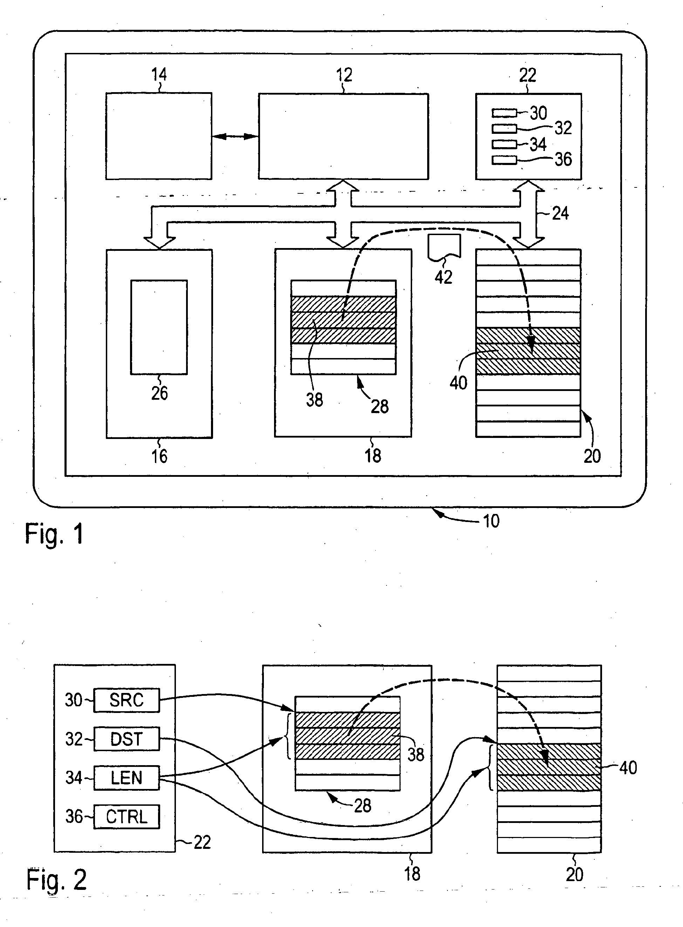

Der in Fig. 1 dargestellte Datenträger 10 ist als Chipkarte gemäß der *Java-Card*-Spezifikation ausgestaltet. Der Datenträger 10 weist auf einem einzigen Halbleiterchip einen Prozessorkern 12, eine Schnittstellenschaltung 14 zur kontaktlosen oder kontaktgebundenen Kommunikation und mehrere in unterschiedlichen Technologien ausgestaltete Speicher auf. Bei dem vorliegenden Ausführungsbeispiel sind diese Speicher ein Festwertspeicher 16, ein Arbeitsspeicher 18 und ein nichtflüchtiger überschreibbarer Speicher 20.

Eine Steuereinheit 22, deren Funktion im folgenden noch eingehend beschrieben werden wird, ist in Fig. 1 als von dem Prozessorkern 12 getrennte Baugruppe gezeigt. In Ausführungsalternativen kann dagegen die Steuereinheit 22 in den Prozessorkern 12 integriert sein.

Alle genannten Baugruppen sind über einen Bus 24 miteinander verbunden. In an sich bekannter Weise dient der Bus 24 zur Übertragung von Adreß-, Daten- und Streuersignalen über getrennte Leitungsbündel und/oder über ein Zeitmultiplexverfahren.

Der Festwertspeicher 16 ist im vorliegenden Ausführungsbeispiel als maskenprogrammiertes ROM ausgebildet. In an sich bekannter Weise enthält der Festwertspeicher 16 ein maschinennahes Betriebssystem, eine virtuelle *Java-Card*-Maschine (JCVM - *Java Card Virtual Machine),* Anwendungsprogrammierschnittstellen (APIs *- Applicatian Programming Interfaces),* Software-komponenten zur Realisierung bestimmter Funktionalitäten des Betriebssystems wie etwa Bibliotheken oder Programme zur Handhabung bestimmter Datenarten (z.B. *Framework*-package), sowie mindestens ein als *Java-Card-Applet* ausgestaltetes Anwendungsprogramm. Diese Software-komponenten sind in der schematischen Darstellung von Fig. 1 allgemein als Programm 26 gezeigt. In Ausführungsalternativen kann sich das Programm 26 auch ganz oder teilweise in dem nichtflüchtigen überschreibbaren Speicher 20 befinden

Der Arbeitsspeicher 18 ist im vorliegenden Ausführungsbeispiel als flüchtiges RAM ausgebildet. Ein reservierter Bereich im Arbeitsspeicher 18 wird als Pufferspeicher 28 verwendet. In Ausführungsalternativen kann dagegen vorgesehen sein, ein gesondertes Speicherfeld - ähnlich wie einen Hardware-Cache - als Pufferspeicher 28 bereitzustellen.

Der nichtflüchtige überschreibbare Speicher 20 ist im vorliegenden Ausführungsbeispiel ein EEPROM oder ein Flash-Speicher. Dieser Speicher ist seitenweise organisiert; die Speicherseiten sind in Fig. 1 durch horizontale Unterteilungen angedeutet. Wegen der technologischen Ausgestaltung des nichtflüchtigen überschreibbaren Speichers 20 sind Schreibvorgänge nur seitenweise möglich. Ist in einer Speicherseite zumindest ein Bit zu schreiben, muß die Seite zunächst vollständig gelöscht werden. Bei jedem Schreibvorgang wird also mindestens eine ganze Speicherseite gelöscht und neu beschrieben. Eine Ausnahme hiervon ergibt sich, wenn der Zustand einer Speicherseite vor dem Schreiben bekannt ist, wie das insbesondere für Neukarten zutrifft. Bei diesen stehen typischerweise alle Zeilen des überschreibbaren Speichers 20 definiert auf 'ff'. Die Speicherseiten des Speichers 20 sind zweckmäßig ferner in mehrere unabhängig voneinander beschreibbare Sektoren untergliedert. Dann kann eine Speicherseite aus einem Sektor gelesen werden, während zugleich eine Speicherseite in einem anderen Sektor gelöscht wird. Um zuverlässig verzögerungsfrei Speicherseiten lesen zu können, sollte, um die Wahrscheinlichkeit klein zu halten, daß ein Schreibvorgang und ein Lesezugriff Speicherseiten im gleichen Sektor betreffen, auch die Größe der Sektoren möglichst klein gehalten werden.

Die Steuereinheit 22 weist im vorliegenden Ausführungsbeispiel vier Register 30 bis 36 auf, die vom Prozessorkern 12 beschrieben und ausgelesen werden können. Durch die Inhalte der Register 30 - 34 werden ein Quellbereich 38 im Pufferspeicher 28 und ein gleichgroßer Zielbereich 40 im nichtflüchtigen überschreibbaren Speicher 20 definiert und einander zugeordnet; der Zielbereich 40 kann dabei, anders als in Fig. 1 dargestellt, auch verteilte Bereiche in dem nichtflüchtigen Speicher 20 belegen. Ebenso kann die Zuordnung von Quellbereich 38 und Zielbereich 40 selbstverständlich auch auf andere Weise als durch Register, z.B. durch Quelle-Ziel-Listen, die jedem Quellbereich 38 einen oder mehrere zugehörige Zielbereiche 40 zuordnen, realisiert sein.

Die Steuereinheit 22 vermag den Inhalt des Quellbereichs 38 in den Zielbereich 40 zu kopieren, ohne daß während des Übertragungsvorgangs die Programmausführung durch den Prozessorkern 12 unterbrochen wird. Der Datenfluß während des Übertragungsvorgangs ist in Fig. 1 durch einen gestrichelten Pfeil veranschaulicht; die Daten selbst sind symbolisch mit dem Bezugszeichen 42 bezeichnet.

Fig. 2 zeigt genauer, daß das erste Register 30 der Steuereinheit 22 die Startadresse des Quellbereichs 38 definiert. Das zweite Register 32 definiert die Startadresse des Zielbereichs 40. Das dritte Register 34 gibt die Länge des Quellbereichs 38 - und damit auch die Länge des Zielbereichs 40 - an, z.B. als Anzahl von zu kopierenden Bytes oder als Anzahl von zu kopierenden Speicherseiten. Das vierte Register 36 ist ein Steuerregister, das es dem Prozessorkern 12 erlaubt, den Kopiervorgang anzustoßen, und das ferner den Zustand der Steuereinheit 22 angibt. Durch Abfrage des Steuerregisters 36 vermag der Prozessorkern 12 festzustellen, ob die Steuereinheit 22 gerade einen Übertragungsvorgang ausführt. Nur wenn dies nicht der Fall ist, dürfen die Register 30 - 34 vom Prozessorkern 12 neu gesetzt werden. Ferner gibt das Steuerregister 36 an, ob der letzte Übertragungsvorgang erfolgreich abgeschlossen wurde oder - z.B. wegen einer Fehlfunktion des nichtflüchtigen überschreibbaren Speichers 20 - fehlgeschlagen ist.

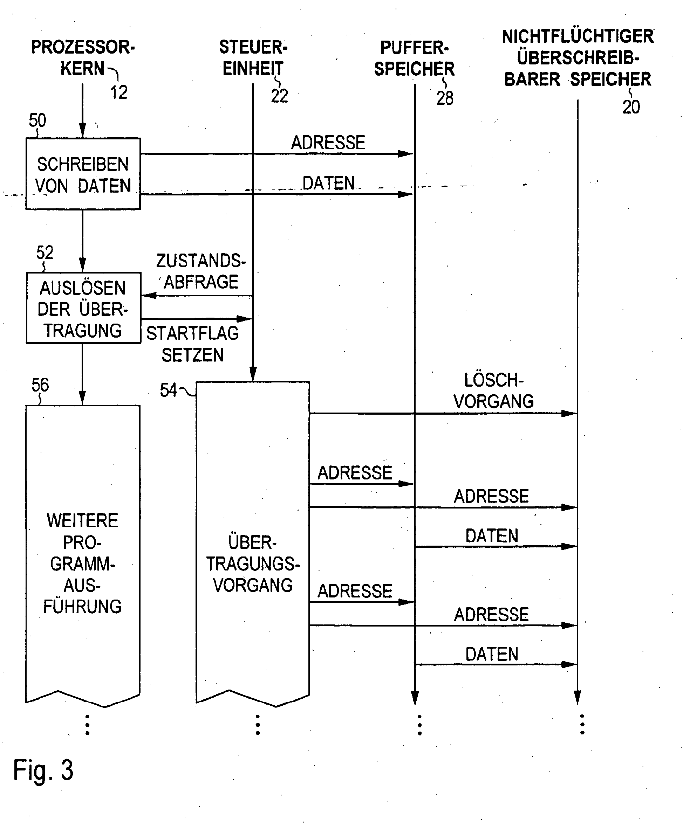

Während des Betriebs des Datenträgers 10 werden Daten, die letztendlich für den nichtflüchtigen überschreibbaren Speicher 20 vorgesehen sind, in den Pufferspeicher 28 geschrieben. Wie in dem beispielhaften Ablaufdiagramm von Fig. 3 gezeigt, werden bei einem solchen Schreibvorgang 50 Adreß- und Datensignale vom Prozessorkern 12 generiert und an den im Arbeitsspeicher 18 angelegten Pufferspeicher 28 ausgegeben.

Vor oder nach jedem Schreibvorgang überprüft der vom Programm 26 gesteuerte Prozessorkern 12 den Füllungszustand des Pufferspeichers 28. Sobald ein vorgegebener Füllungsgrad erreicht ist, startet der Prozessorkern 12 mit einem Auslöseschritt 52 den Übertragungsvorgang 54. Hierzu überprüft der Prozessorkern 12 zunächst durch eine Abfrage des Steuerregisters 36, ob bereits ein Übertragungsvorgang läuft. Ist dies der Fall, wird zunächst das Ende dieser bereits laufenden Übertragung abgewartet. Sonst trägt der Prozessorkern 12 den Beginn des Quellbereichs 38 in das erste Register 30 ein. Der Beginn des Zielbereichs 40 wird in das zweite Register 32 eingetragen, und die Anzahl der zu übertragenden Bytes oder Seiten wird in das dritte Register 34 geschrieben. Durch Setzen eines Startbits im Steuerregister 26 wird dann der Übertragungsvorgang 54 begonnen.

Beim Übertragungsvorgang 54 wird zunächst die erste im nichtflüchtigen überschreibbaren Speicher 20 zu überschreibende Speicherseite gelöscht. Die Steuereinheit 22 sorgt dann für die Übertragung der in diese Seite einzuschreibenden Daten vom Quellbereich 38 in den Zielbereich 40. Hierzu gibt die Steuereinheit 22, wie in Fig. 3 veranschaulicht, sukzessive je eine Start-und eine Zieladresse an den Arbeitsspeicher 18 bzw. den nichtflüchtigen überschreibbaren Speicher 20 aus und veranlaßt dann den Arbeitsspeicher 18, die an der Quelladresse enthaltenen Daten über den Bus 24 zum nichtflüchtigen überschreibbaren Speicher 20 zu übertragen. Der Prozessorkern 12 ist hierbei nicht involviert.

Während der Datenübertragung 54 kann der Prozessorkern 12 die Ausführung des Programms 26 fortsetzen. Bei dieser weiteren Programmausführung 56 kann der Prozessorkern 12 ohne Wartezeit Daten in Bereiche des Pufferspeichers 28, die sich vom Quellbereich 38 unterscheiden, schreiben. Besitzt der nichtflüchtige Speicher 20 eine Sektorisierung, kann der Speicher 20 während der Datenübertragung 54 auch ohne Wartezeit gelesen werden, sofern der Lesezugriff nicht auf denselben Sektor geschieht, in den gerade die Datenübertragung 54 erfolgt. Ein Wartezustand des Prozessorkerns 12 ergibt sich nur dann, wenn entweder der Pufferspeicher 28 voll ist, wenn ein neuer Übertragungsvorgang gestartet werden soll, solange der bisherige Übertragungsvorgang 54 noch nicht abgeschlossen ist, oder wenn ein Lesezugriff auf eine Speicherseite in denselben Sektor des nichtflüchtigen Speichers 20 erfolgen soll, in dem gerade geschrieben wird.

Ist der Übertragungsvorgang 54 beendet, erzeugt die Steuereinheit 22 zweckmäßig einen Interrupt, der dem Prozessorkern 12 die Beendigung anzeigt. Abhängig von der implementierten Strategie zur Verwaltung des Pufferspeichers 28 kann der Interrupt der Steuereinheit 22 dazu dienen, den nächsten Auslöseschritt 52 zu starten.

Die Verwaltung des Pufferspeichers 28 erfolgt durch das vom Prozessorkern 12 ausgeführte Programm 26. Hierbei werden Vorgehensweisen eingesetzt, die zur Verwaltung von "Software-Caches" als solche bekannt sind. Dies betrifft insbesondere die Frage, bei welchem Füllungsgrad des Pufferspeichers 28 der Übertragungsvorgang 54 begonnen werden soll, und die Frage, welche Seiten des Pufferspeichers 28 bei einem Übertragungsvorgang in den nichtflüchtigen überschreibbaren Speicher 20 ausgelagert werden sollen.

Im Hinblick auf die erstgenannte Frage kann es in manchen Ausgestaltungen günstig sein, nach jedem Schreiben von Daten in den Pufferspeicher 28 sogleich einen Übertragungsvorgang zu beginnen. Hierdurch wird die Steuereinheit 22 maximal genutzt; der nichtflüchtige überschreibbare Speicher 20 wird jedoch durch viele Schreibvorgänge belastet. Als anderes Extrem könnte der Übertragungsvorgang erst begonnen werden, wenn keine weitere Speicherseite im Pufferspeicher 28 mehr frei ist. Dies schont den nichtflüchtigen überschreibbaren Speicher 20. Allerdings vergrößert sich die Wahrscheinlichkeit, daß bei einem weiteren Schreibvorgang die Programmausführung angehalten werden muß, bis wieder genügend Platz im Pufferspeicher 28 geschaffen wurde. In vielen Ausgestaltungen wird daher ein Kompromiß zwischen den beiden genannten Extremen vorteilhaft sein.

Im Hinblick auf die oben an zweiter Stelle genannte Frage, welche Seiten zur Auslagerung ausgewählt werden sollen, sind bereits eine Vielzahl von Auslagerungsstrategien vorgeschlagen worden, die auch im Zusammenhang mit der vorliegenden Erfindung einsetzbar sind. So kann z.B. zunächst diejenige Seite des Pufferspeichers 28 in den nichtflüchtigen überschreibbaren Speicher 20 geschrieben werden, die am längsten nicht benutzt wurde; diese Cache-Strategie ist unter der Bezeichnung LRU-Strategie (LRU = *least recently used*) bekannt. In bevorzugten Ausgestaltungen der Erfindung ist jedoch vorgesehen, daß bei jedem Übertragungsvorgang 54 der gesamte gültige Inhalt des Pufferspeichers 28 in den nichtflüchtigen überschreibbaren Speicher 20 kopiert wird. Der Pufferspeicher 28 wird dadurch vollständig geleert.

## Patentansprüche

1. Verfahren zum Schreiben von Daten (42) in einen nichtflüchtigen überschreibbaren Speicher (20) für einen, einen Prozessorkern (12) und einen Pufferspeicher (28) aufweisenden, tragbaren Datenträger (10), der der Java-Card-Spezifikation entspricht,
wobei der nichtflüchtige, überschreibbare Speicher (20), der Prozessorkern (12) und der Pufferspeicher (28) auf einem einzigen Halbleiterchip ausgebildet sind und der Prozessorkern (12) ein Programm (26) ausführt, das ein Anwendungsprogramm enthält,
wobei der Prozessorkern (12) bei der Ausführung des Programms (26) unmittelbar Schreibzugriffe auf den Pufferspeicher (28) und Lesezugriffe auf den nichtflüchtigen, überschreibbaren Speicher (20) vornimmt, **gekennzeichnet durch** die Schritte:
a) Schreiben der Daten (42) in den Pufferspeicher (28) unter Steuerung des von dem Prozessorkern (12) ausgeführten Programms (26), und
b) Übertragen der Daten (42) von dem Pufferspeicher (28) in den nichtflüchtigen überschreibbaren Speicher (20),
wobei der tragbare Datenträger (10) mit einer Steuereinheit (22) ausgestattet wird, die die Daten (42) parallel zur weiteren Ausführung des Programms (26) **durch** den Prozessorkern (12) von dem Pufferspeicher (28) in den nichtflüchtigen überschreibbaren Speicher (20) überträgt.

2. Verfahren nach Anspruch 1, **dadurch gekennzeichnet, daß** die Verwendung des Pufferspeichers (28) durch das vom Prozessorkern (12) ausgeführte Programm (26) gesteuert wird.

3. Verfahren nach Anspruch 1 oder Anspruch 2, **dadurch gekennzeichnet, daß** bei einem Lesezugriff des Prozessorkerns (12) zunächst überprüft wird, ob die gewünschten Daten im Pufferspeicher (28) enthalten sind, und daß die Daten in Abhängigkeit vom Ergebnis dieser Überprüfung aus dem Pufferspeicher (28) bzw. dem nichtflüchtigen überschreibbaren Speicher (20) gelesen werden.

4. Verfahren nach einem der Ansprüche 1 bis 3, **dadurch gekennzeichnet, daß** das Übertragen der Daten (42) von dem Pufferspeicher (28) in den nichtflüchtigen überschreibbaren Speicher (20) durch den Prozessorkern (12) in Abhängigkeit von einem Füllungsgrad des Pufferspeichers (28) ausgelöst wird.

5. Verfahren nach einem der Ansprüche 1 bis 4, **dadurch gekennzeichnet, daß** die Steuereinheit (22) dem Prozessorkern (12) eine Rückmeldung über die Übertragung der Daten in den nichtflüchtigen überschreibbaren Speicher (20) bereitstellt.

6. Verfahren nach Anspruch 5, **dadurch gekennzeichnet, daß** ein neuer Übertragungsvorgang frühestens ausgelöst wird, nachdem der vorherige Übertragungsvorgang beendet worden ist.

7. Verfahren nach einem der Ansprüche 1 bis 6, **dadurch gekennzeichnet, daß** der Pufferspeicher (28) und der nichtflüchtige überschreibbare Speicher (20) seitenweise organisiert sind.

8. Verfahren nach einem der Ansprüche 1 bis 7, **dadurch gekennzeichnet, daß** der Pufferspeicher (28) als Bereich in einem Arbeitsspeicher (18) des tragbaren Datenträgers (10) angelegt ist.

9. Verfahren nach einem der Ansprüche 1 bis 8, **dadurch gekennzeichnet, daß** der nichtflüchtige überschreibbare Speicher (20) ein EEPROM oder ein Flash-Speicher ist.

10. Tragbarer Datenträger (10), der der Java-Card-Spezifikation entspricht, insbesondere Chipkarte oder Chipmodul, mit einem Prozessorkern (12), einem Pufferspeicher (28) und einem nichtflüchtigen überschreibbaren Speicher (20), wobei der
nichtflüchtige überschreibbare Speicher (20), der Prozessorkern (12) und der Pufferspeicher (28) auf einem einzigen Halbleiterchip ausgebildet sind, und der Prozessorkern (12) ein Programm (26) ausführt, das ein Anwendungsprogramm enthält, wobei der Prozessorkern (12) bei der Ausführung des Programms (26) unmittelbar Schreibzugriffe auf den Pufferspeicher (38) und Lesezugriffe auf den nichtflüchtigen, überschreibbaren Speicher (20) vornimmt,
**gekennzeichnet durch** eine Steuereinheit (22), die dazu eingerichtet
ist, parallel zur Abarbeitung eines Programms (26) **durch** den Prozessorkern (12) Daten (42) aus dem Pufferspeicher (28) in den nichtflüchtigen überschreibbaren Speicher (20) zu übertragen.

11. Tragbarer Datenträger (10) nach Anspruch 10, **dadurch gekennzeichnet, daß** die Steuereinheit (22) eine Mehrzahl von Registern (30 - 36) aufweist, deren Inhalte einen Quellbereich (38) im Pufferspeicher (28) und einen Zielbereich (40) im nichtflüchtigen überschreibbaren Speicher (20) für die Übertragung der Daten (42) definieren.

12. Tragbarer Datenträger (10) nach Anspruch 10 oder Anspruch 11, **dadurch gekennzeichnet, daß** er zur Ausführung eines Verfahrens nach einem der Ansprüche 1 bis 9 eingerichtet ist.

13. Computerprogrammprodukt mit Programmbefehlen, die zur Ausführung durch einen tragbaren Datenträger (10) nach einem der Ansprüche 10 bis 11 vorgesehen sind, wobei die Programmbefehle den Datenträger (10) dazu veranlassen, ein Verfahren nach einem der Ansprüche 1 bis 9 auszuführen.

## Claims

1. A method for writing data (42) into a non-volatile rewritable memory (20) for a portable data carrier (10), which comprises a processor core (12) and a buffer memory (28), and which satisfies the Java Card specification, the non-volatile rewritable memory (20), the processor core (12) and the buffer memory (28) being formed on a single semiconductor chip and the processor core (12) executing a program (26) containing an application program, the processor core (12), during the execution of the program (26), directly carrying out write accesses to the buffer memory (28) and read accesses to the non-volatile rewritable memory (20), **characterised by** the steps:
a) writing the data (42) into the buffer memory (28) under the control of the program (26) executed by the processor core (12), and
b) transmitting the data (42) from the buffer memory (28) into the non-volatile rewritable memory (20),
wherein the portable data carrier (10) is equipped with a control unit (22) that transmits the data (42), parallel to the continued execution of the program (26) by the processor core (12), from the buffer memory (28) into the non-volatile rewritable memory (20).

2. The method according to claim 1, **characterised in that** the use of the buffer memory (28) is controlled by the program (26) executed by the processor core (12).

3. The method according to claim 1 or claim 2, **characterised in that**, in case of a read access by the processor core (12), a check is first performed as to whether the desired data are contained in the buffer memory (28), and that, depending on the result of this check, the data are read from the buffer memory (28) or the non-volatile rewritable memory (20).

4. The method according to any one of the claims 1 to 3, **characterised in that** the transmission of the data (42) from the buffer memory (28) into the non-volatile rewritable memory (20) is triggered by the processor core (12) depending on a filling level of the buffer memory (28).

5. The method according to any one of the claims 1 to 4, **characterised in that** the control unit (22) provides the processor core (12) with a feedback regarding the transmission of the data into the non-volatile rewritable memory (20).

6. The method according to claim 5, **characterised in that** a new transmission process is triggered at the earliest after the previous transmission process has been completed.

7. The method according to any one of the claims 1 to 6, **characterised in that** the buffer memory (28) and the non-volatile rewritable memory (20) are organised in a paged manner.

8. The method according to any one of the claims 1 to 7, **characterised in that** the buffer memory (28) is designed as an area in a working memory (18) of the portable data carrier (10).

9. The method according to any one of the claims 1 to 8, **characterised in that** the non-volatile rewritable memory (20) is an EEPROM or a flash memory.

10. A portable data carrier (10) which satisfies the Java Card specification, in particular a chip card or chip module, comprising a processor core (12), a buffer memory (28) and a non-volatile rewritable memory (20), the non-volatile rewritable memory (20), the processor core (12) and the buffer memory (28) being formed on a single semiconductor chip and the processor core (12) executing a program (26) containing an application program, the processor core (12), during the execution of the program (26), directly carrying out write accesses to the buffer memory (38) and read accesses to the non-volatile rewritable memory (20),
**characterised by** a control unit (22) configured to transmit data (42), parallel to the running of a program (26) by the processor core (12), from the buffer memory (28) into the non-volatile rewritable memory (20).

11. The portable data carrier (10) according to claim 10, **characterised in that** the control unit (22) comprises a plurality of registers (30 - 36) whose contents define a source area (38) in the buffer memory (28) and a target area (40) in the non-volatile rewritable memory (20) for the transmission of the data (42).

12. The portable data carrier (10) according to claim 10 or claim 11, **characterised in that** it is configured to carry out a method according to any one of the claims 1 to 9.

13. A computer program product comprising program instructions provided for being executed by a portable data carrier (10) according to any one of the claims 10 to 11, the program instructions causing the data carrier (10) to carry out a method according to any one of the claims 1 to 9.

## Revendications

1. Procédé d'écriture de données (42) sur une mémoire non-volatile et réinscriptible (20) pour un support de données portatif (10) conçu en conformité avec les spécifications Java-Card, comprenant un coeur de processeur (12) et une mémoire tampon (28); la mémoire non-volatile et réinscriptible (20), le coeur du processeur (12) et la mémoire tampon (28) étant montés sur une même puce semi-conductrice et le coeur du processeur (12) exécutant un programme (26) qui contient un programme d'application; le coeur du processeur (12) accède directement en écriture sur la mémoire tampon (28) et en lecture sur la mémoire non-volatile et réinscriptible (20) lors de l'exécution du programme (26), **caractérisé par** les étapes suivantes :
a. écriture des données (42) dans la mémoire tampon (28) sous le contrôle du programme (26) exécuté par le coeur du processeur (12) et,
b. transfert des données (42) de la mémoire tampon (28) dans la mémoire
non-volatile et réinscriptible (20),
le support de données portatif (10) étant équipé d'une unité de commande (22), qui transfère les données (42), parallèlement à la poursuite de l'exécution du programme (26) par le coeur du processeur (12), de la mémoire tampon (28) vers la mémoire non-volatile et réinscriptible (20).

2. Procédé selon la revendication (1), **caractérisé en ce que** l'utilisation de la mémoire tampon (28) est contrôlé par le programme (26) exécuté par le coeur du processeur (12).

3. Procédé selon les revendications 1 ou 2, **caractérisé en ce que** lors d'un accès de lecture par le coeur du processeur (12), il est d'abord vérifié, si les données demandées sont disponibles dans la mémoire tampon (28) et que selon le résultat de cette vérification, les données seront lues à partir de la mémoire tampon (28) ou de la mémoire non-volatile et réinscriptible (20).

4. Procédé selon l'une des revendications 1 à 3, **caractérisé par le fait que** le transfert des données (42) de la mémoire tampon (28) vers la mémoire non-volatile et réinscriptible (20) est déclenché par le coeur du processeur (12) selon le degré de remplissage de la mémoire tampon (28).

5. Procédé selon l'une des revendications 1 à 4, **caractérisé en ce que** l'unité de commande (22) met à la disposition du coeur du processeur (12) un message de retour sur l'état du transfert des données vers la mémoire non volatile et réinscriptible (20).

6. Procédé selon la revendication 5, **caractérisé en ce qu'**un nouveau transfert de données sera au plus tôt déclenché après la fin du transfert précédent.

7. Procédé selon l'une des revendications 1 à 6, **caractérisé en ce que** la mémoire tampon (28) et la mémoire non-volatile et réinscriptible (20) sont des mémoires paginées.

8. Procédé selon l'une des revendications 1 à 7, **caractérisé en ce que** la mémoire tampon (28) occupe une plage de la mémoire principale (18) du support de données portatif (10).

9. Procédé selon l'une des revendications 1 à 8, **caractérisé en ce que** la mémoire non-volatile et réinscriptible (20) est une mémoire de type EEPROM ou une mémoire flash.

10. Support de données portatif (10) conçu en conformité avec les spécifications Java-Card, en particulier carte à puce ou module de puce avec un coeur de processeur (12), un mémoire tampon (28) et une mémoire non-volatile réinscriptible (20), la mémoire non-volatile réinscriptible (20), le coeur du processeur (12) et la mémoire tampon (28) étant montés sur une même puce semi-conductrice et le coeur du processeur (12) exécutant un programme (26) qui contient un programme d'application; le coeur du processeur (12) accédant directement en écriture sur la mémoire tampon (28) et en lecture sur la mémoire non-volatile et réinscriptible (20) lors de l'exécution du programme (26),
**caractérisé par** une unité de commande (22) qui transfère des données (42), parallèlement à la poursuite de l'exécution du programme (26) par le coeur du processeur (12), de la mémoire tampon (28) vers la mémoire non-volatile et réinscriptible (20).

11. Support de données portatif (10) selon la revendication 10, **caractérisé en ce que** l'unité de commande (22) comporte des registres (30-36), dont le contenu définit une zone source (38) dans la mémoire tampon (28) et une zone de destination (40) dans la mémoire non-volatile et réinscriptible (20) relative à la transmission des données.

12. Support de données portatif (10) selon la revendication 10 ou la revendication 11, **caractérisé en ce que** l'exécution d'un procédé est établie selon l'une des revendications 1 à 9.

13. Produit d'un programme d'ordinateur avec des commandes à exécuter par un support de données portatif (10) selon l'une des revendications 10 à 11, tel que les commandes amènent le support de données à exécuter un processus selon l'une des revendications 1 à 9.
